# EUROPEAN PATENT APPLICATION

(11) **EP 0 552 466 A2**
(43) Date of publication of application: **28.07.1993**
(21) Application number: 92121262.7
(22) Date of filing: 14.12.1992
(51) Int. Cl.: H01L 21/20

(54) **Method for joining semiconductor substrates**

(30) Priority: 24.01.1992 JP 51052/92
(71) Applicant: HONDA GIKEN KOGYO KABUSHIKI KAISHA, Minato-ku Tokyo (JP)
(72) Inventor: Yamakawa, Hiroshi, c/o Kabushiki Kaisha, Wako-shi, Saitama (JP)
(74) Representative: Fincke, Karl Theodor, Dipl.-Phys. Dr.

(57) **Abstract**

Disclosed is method for joining semiconductor substrates, in which two silicon semiconductor substrates, at least one of which has a layer of gold (Au) previously deposited on its joining surface, are matched together at their joining surfaces and heated to form an alloyed joint of silicon and gold. This method is to use only one kind of soldering material and form an eutectically alloyed joint firmly uniting two semiconductor substrate by heating at relatively low temperature, thereby thermal affection on elements placed near the soldering portion can be prevented.

## Description

### BACKGROUND OF THE INVENTION

The present invention relates to a method for joining semiconductor substrates by using soldering material of eutectic alloy.

Recently, as known from Japanese laid open patent publication No. 29858/91, a gas rate sensor has been developed, which, being supplied with gas constantly forced by a pump into a gas path through a nozzle hole, determines a degree of the gas flow deflection in the gas path by the action of angular velocity on the sensor body by means of a pair of heat wires having temperature-sensitive resistance and arranged parallel with each other in gas deflecting direction in the gas path, and is featured by that the sensor body having therein the gas path and the paired heat wires is formed on semiconductor substrates by micro-machining method using IC technology.

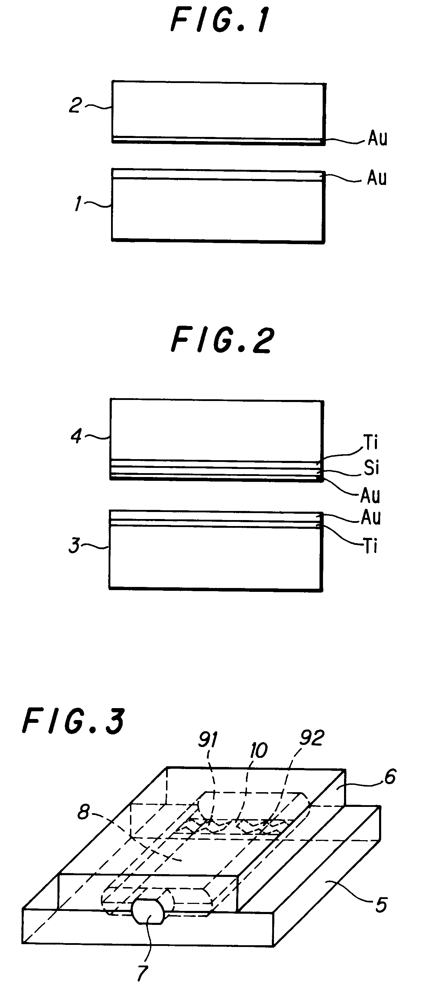

As shown in Figs. 3 to 5, the above-mentioned type of gas rate sensor has a body composed of two semiconductor substrates, i.e. an upper and a lower substrates 5 and 6, each of which has an etched thereon half-hole 71 and an etched thereon half-groove 81, and which are placed on each other to form a nozzle hole 7 and a gas path 8.

In Figs. 3 to 5, a pair of heat wires 91 and 92 is formed by pattern on the upper surface of a bridge portion 10 etched across the gas path on the lower semiconductor substrate 5.

In joining the lower and upper semiconductor substrates 5 and 6 of the sensor body it is required to attain high strength and gas tightness of the joint so as to eliminate the possibility of gas leaking therethrough.

Japanese laid open patent publication No. 56476/83 discloses such a conventional method for joining semiconductor substrates, which is intended to join two micro-machined semiconductor substrates composing a pressure sensor body by use of glass solder in such a way that two substrates are matched together and heated at their joining portion under pressure at temperature of about 470°C to form a sound and air-tight joint therebetween.

The above-mentioned method is effective to solder two semiconductor substrates of a pressure sensor, but it is not applicable for a gas rate sensor composed of two semiconductor substrates having temperature-sensitive resistive elements in a gas path because the characteristic of said elements may be impaired by affection of high temperature of melting glass solder.

Anode joining method using Pyrex glass and direct silicon joining method utilizing thermal oxidation have been also published, however the former requires high voltage application and the latter requires mirror-like finishing the joining surfaces of the substrate at an atomic level of cleanness.

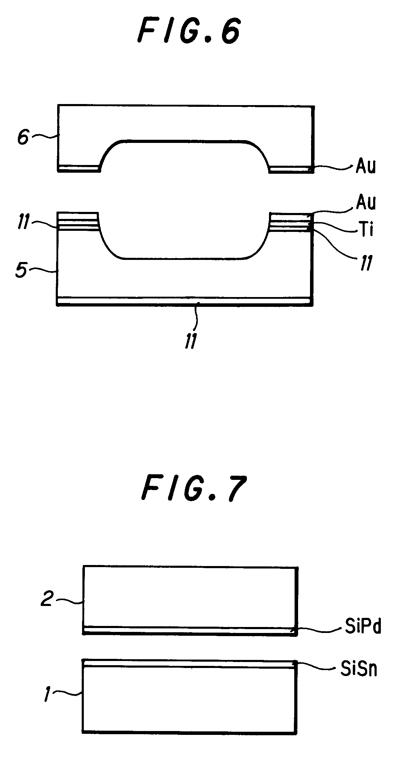

In another conventional method, as shown in Fig. 7, two silicon semiconductor substrates 1 and 2 are joined in such a way that a SiSn-layer is formed on the joining surface of the substrate 1 and a SiPd-layer is formed on the joining surface of the substrate 2, and then two substrates matched together at their joining surfaces and heated with pressing to form an alloyed joint of SiSn and SiPd therebetween. This method however is laborious and requires to use two kinds of soldering materials (SiSn and SiPd) in form of soldering layers previously deposited on the joining surfaces of the respective substrates.

The problems of said conventional method are as follows:
When two semiconductor substrates are joined with soldering material by heating with pressing so as to form a gas rate sensor body, temperature-sensitive resistance elements placed within a gas path near to soldering portion of the gas sensor body may be affected by high temperature of soldering.

Furthermore, in this case it is needed to previously form two layers of different kinds of soldering materials on respective joining surfaces of two substrates. The use of two kinds of solders complicates material control and soldering work.

### SUMMARY OF THE INVENTION

The object of the present invention is to avoid the above-mentioned problems and provide a method for joining two semiconductor substrates, which means that two semiconductor substrates are firmly and tightly joined by use of one kind of soldering material without impairing mounted therein elements due to soldering temperature. This has been attained by forming a layer of gold (Au) on at least one of joining surfaces of two silicon semiconductor substrates and then by heating the two substrates matched together at the joining surfaces under pressure at a relatively low temperature to form therebetween hard soldered alloy of Au and Si.

### BRIEF DESCRIPTION OF DRAWINGS

Fig. 1 is a front view of an example of two semiconductor substrates to be joined with each other according to present invention.

Fig. 2 is a front view of another example of two semiconductor substrates to be joined with each other according to the present invention.

Fig. 3 is a construction view in perspective of a gas rate sensor body formed of micro-machined semiconductor substrates.

Fig. 4 is a plan view of the lower semiconductor substrate of the sensor body shown in Fig. 3.

Fig. 5 is a front sectional view of the sensor body shown in Fig. 3.

Fig. 6 is a front view of an example of joining a lower and an upper semiconductor substrates of a gas rate sensor body according to the present invention.

Fig. 7 is a front view of two conventional semiconductor substrates to be joined.

In the drawings, 1 and 2 are silicon semiconductor substrates, 3 and 4 are conventional semiconductor substrates, 5 is a lower semiconductor substrate, 6 is an upper semiconductor substrate, 7 is a nozzle hole, 8 is a gas path, 91 and 92 are heat wires.

### DESCRIPTION OF THE PREFERRED EMBODIMENTS

Referring to Fig. 1, there is shown an example of method for joining semiconductor substrates, which is proposed by the present invention and by which two silicon semiconductor substrates 1 and 2 can be joined in the following steps: an Au-layer of about 1µm in thickness is formed on the joining surface of the substrate 1 and an Au-layer of about 0.05µm in thickness is formed on the joining surface of the substrate 2 by depositing or sputtering, two substrates are butted to each other at their joining surfaces under a certain pressure and then heated at 370°C to form an eutectic alloy of Au (94%) and Si (6%) in joining portion thereof.

In this case the Au layers formed on the joining surfaces must be thin enough not to cause uneven distribution of components in alloying.

To avoid insufficient joining the substrates it is necessary to heat their soldering surfaces at temperature exceeding the eutectic point of Au-Si alloy by some tens degree. In practice, they are heated, for example, at 430°C for one hour.

Heating must be conducted in nitrogen gas so as to avoid oxidation of the joining surfaces of two substrates.

Furthermore, in order to prevent the joining surfaces of the semiconductor substrates 1 and 2 from natural oxidation and/or formation of carbon impurities during Au-deposition it is effective to wash by etching solution the joining surface of each substrate before application of Au-layers thereon.

According to the present invention, it is also possible to join the semiconductor substrates 1 and 2 by applying a 1µm thick layer of Au only on one of the substrates.

The eutectic alloy of Au-Si is excellent in its electro-chemical corrosion resistivity and wettability and forms a reliable hard alloyed joint of the semiconductor substrates 1 and 2, which has high stability and binding strength at temperature below the eutectic point.

The semiconductor substrates joined by applying a 1µm thick Au-layer on the joining surface of the substrate 1 and a 0.05 µm thick Au-layer on the joining surface of the substrate 2 and then by heating the butted substrates in nitrogen gas at 430°C for 1 hour are tested as follows:

A 6 mm by 6 mm test piece cut-out from the above-mentioned joined substrates was bonded to a jig and tested for tensile strength of its joint. The test piece was stretched by force within the measurable range (not less than 10 kgf) at which the test piece can not come off from the pulling Jig. The substrates could bear the test and no peeling-off was found in joined portion.

The same test piece was further subjected to thermal ageing on the condition of 100 cycles of thermal shocking at -30°C and +85°C for 10 minutes each. No peeling off was found in the joined portion of the substrates after stretching by the force of above-mentioned measuring range.

As stated above, the present invention provides the possibility of firmly and tightly joining two semiconductor substrates 1 and 2 by use of only one kind of solder material (Au) and also by applying the soldering layer on at least one joining surface of the substrate 1 or 2, thereby making it easier to control soldering material and also joining work.

Furthermore, the method proposed by the present invention is capable of forming the eutectic alloy of joining portion of the semiconductor substrates by heating at relatively low temperature, thereby attaining effective prevention of undesirable thermal affection on any internal element near the soldering portion, for example, heat wires placed on one of the semiconductor substrates of the gas rate sensor body.

Referring now to Fig. 2, there are shown two semiconductor substrates 3 and 4 made of material other than silicon, which according to the present invention can be joined in the following manner:

A 0.1µm thick layer of Ti as base material is deposited on joining surfaces of both substrates 3 and 4 for improving adhesion and then a 1µm thick layer of Au is deposited on the Ti-layer of the substrate 3 and a 0.5µm thick layer of Si and a subsequent 0.05 µm thick layer of Au are deposited on the Ti-layer of the substrate 4. Two substrates 3 and 4 are now matched with each other at their joining surfaces and heated thereat under pressure to form an alloyed joint of Si and Au therebetween.

Even in this case it is possible to join the substrate 4 having an upper layer of Si (omitting Au-depositing) with the substrate 3 having an upper layer of Au by heating to form an Au-Si alloyed joint therebetween.

The base layers for improving adhesion of the joining surfaces of the substrates may be of nickel or platinum other than titanium (Ti).

Fig. 6 shows an example of joining a lower and an upper semiconductor substrates 5 and 6 composing a gas rate sensor body by the method according to the present invention.

A mask pattern 11 of SiN previously formed on a specified place on the lower silicon substrate 5 is etched by anisotropical water solution of KOH to form a groove and then a layer of base material, e.g. titanium and a subsequent 1 µm thick layer of Au are deposited in said order on the mask pattern 11 of the joining surface,

In the like manner, a mask pattern 11 of SiN previously formed on a specified place on the upper silicon substrate 6 is etched by anisotropical water solution of KOH to form a groove, a mask pattern is then removed off by etching treatment to expose the silicon surface of the substrate 6 and a 0.05 µm thick layer of Au is subsequently deposited on the exposed joining surface thereof.

As is apparent from the above-mentioned, according to the present invention, it is possible to easily and securely join the lower and the upper micro-machined semiconductor substrates 5 an 6 by using thin film forming technology.

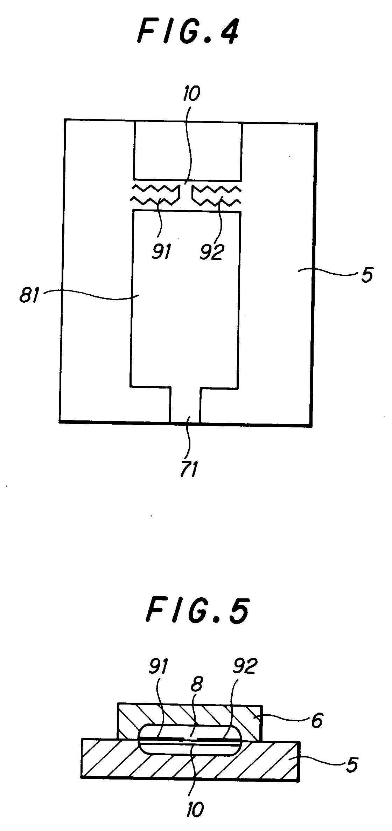

As shown in Fig. 4, the lower semiconductor substrate 5 has heat wires 91 and 92 formed thereon which may be impaired if the mask pattern is removed off by use of etching liquid. This is the reason why the mask pattern 11 is left on the lower semiconductor substrate 5.

As mentioned above, the method for joining semiconductor substrates according to the present invention offers such an advantage that two semiconductor substrates can be firmly joined by using one kind of soldering material, i.e. gold (Au) under stable thermal and chemical conditions, and an eutectic alloy for joining the substrates can be formed by heating at relatively low temperature, thereby thermal affection on elements placed near the soldering portion can be effectively avoided.

## Claims

1. Method for joining semiconductor substrates, in which two silicon semiconductor substrates, at least one of which has a layer of gold (Au) previously deposited on its joining surface, are placed on each other and heated at joining portions under pressure to form an alloyed joint of silicon and gold therebetween.

2. Method for joining semiconductor substrates according to claim 1, characterized in that at least one of two semiconductor substrates is subjected to etching treatment of its joining surface before depositing a gold layer thereon.

3. Method for joining semiconductor substrates according to claim 1, characterized in that two semiconductor substrates is heated in nitrogen gas at a temperature higher than eutectic point of silicon and gold.

4. Method for joining semiconductor substrates, in which a layer of base metal of e.g. titanium, nickel or platinum is deposited on joining surfaces of two semiconductor substrates respectively, a layer of gold is deposited on the base metal layer of one substrate and a layer of silicon is deposited on the base metal layer of the other substrate and then two substrates are placed on each other and heated at joining portions under pressure to form an alloyed joint of silicon and gold therebetween.

5. Method for joining semiconductor substrates according to claim 4, characterized in that a layer of gold is also formed on the silicon layer of the other semiconductor substrate.
